# EUROPÄISCHE PATENTSCHRIFT

(11) **EP 2 020 082 B1**
(45) Veröffentlichungstag und Bekanntmachung des Hinweises auf die Patenterteilung: **30.06.2010**
(21) Anmeldenummer: 07764334.4
(22) Anmeldetag: 20.05.2007
(51) Int. Cl.: H03K 17/10

(54) **HOCHLEISTUNGSSCHALTMODUL UND VERFAHREN ZUR ERZEUGUNG VON SCHALTSYNCHRONITÄT BEI EINEM HOCHLEISTUNGSSCHALTMODUL**
HIGH-POWER SWITCHING MODULE, AND METHOD FOR THE GENERATION OF SWITCHING SYNCHRONISM IN A HIGH-POWER SWITCHING MODULE
MODULE DE COMMUTATION HAUTE PERFORMANCE ET PROCÉDÉ DE GÉNÉRATION D'UN SYNCHRONISME DE COMMUTATION DANS UN MODULE DE COMMUTATION HAUTE PERFORMANCE

(30) Priorität: 23.05.2006 DE 102006024938
(43) Veröffentlichungstag der Anmeldung: 04.02.2009
(73) Patentinhaber: LTB-Lasertechnik Berlin GmbH, 12489 Berlin (DE); Spree Hybrid & Kommunikationstechnik GmbH, 12681 Berlin (DE)
(72) Erfinder: SCHURACK, Johannes, 12487 Berlin (DE); TROMPA, Thomas, 10249 Berlin (DE); SEGSA, Karl Heinz, 12555 Berlin (DE); MÜLLER, Joachim, 16356 Ahrensfelde (DE)
(74) Vertreter: Hoffmann, Heinz-Dietrich
(86) Internationale Anmeldenummer: PCT/DE2007/000921
(87) Internationale Veröffentlichungsnummer: WO 2007/134589

(56) Entgegenhaltungen:
- DE-A1- 4 040 164
- DE-C1- 4 240 647
- DE-C1- 10 216 707

## Beschreibung

Die Erfindung bezieht sich auf ein Hochleistungsschaltmodul zur direkten Pulsenergiespeisung eines Verbrauchers mit in Reihe geschalteten Schaltstufen, die jeweils einen Halbleiterschalter mit Anoden-, Kathoden- und Steueranschluss und ein auf den Halbleiterschalter einwirkendes, mit Hilfsenergie von einem Pulstreiber versorgtes Steuemetzwerk zur Schaltbeeinflussung des Halbleiterschalters aufweisen, wobei das Steuemetzwerk zumindest einen Steuerwiderstand und eine bezüglich ankommender Schaltpulse von dem alle Schaltstufen versorgenden Pulstreiber in Durchlassrichtung gepolte Steuerdiode umfasst und wobei eine Snubberkapazität und ein zusätzlicher Synchronisierwiderstand parallel zum Halbleiterschalter zwischen Anoden- und Kathodenanschluss geschaltet sind, sowie auf ein Verfahren zur Erzeugung von Schaltsynchronität bei einem Hochleistungsschaltmodul.

In vielen Systemen der Lasertechnik, Optik, Optoelektronik und Elektronik müssen mit hohen Spannungen Laststrecken geschaltet werden. Die Last muss in sehr kurzer Zeit, insbesondere unter 10 ns, in einen niederohmigen Zustand gebracht werden, um schnell und effizient hohe Ströme einspeisen oder Kapazitäten umzuladen zu können. Beispiele sind der Gasentladungskanal eines transversal elektrisch angeregten Gasentladungslasers, beispielsweise CO₂-Lasers, zur Erzeugung von Lichtpulsen geringer Breite, die Ansteuerung von Pockelszellen zur Lichtmodulation und Einrichtungen zur Steuerung von Ionenflugbahnen in Time-Of-Flight-Spektrometern. Die Schaltvorgänge müssen sehr schnell ablaufen, es müssen Folgefrequenzen bis zu einigen kHz möglich sein. Es besteht somit ein großer Bedarf an einem robusten, langlebigen Hochleistungsschaltmodul, das in einem weiten Betriebsspannungsbereich schnelles Einspeisen von Strömen oder Laden und Entladen von Kapazitäten ermöglicht.

Für den Einsatz eines solchen Hochleistungsschaltmoduls bei einem Gasentladungslaser ist beispielsweise folgendes Leistungsprofil wünschenswert:

| | |
|---|---|
| Schaltspannung | 5 bis 25 kV |
| sichere Sperrspannung | 15 % über der Schaltnennspannung |
| Schaltzeit | 5 -15 ns |
| Sperrverzögerungszeit | max. 5 µs |
| Time Jitter Schaltvorgang | 0,6 bis max. 1,5 ns |
| Wiederholfrequenz | 100 bis 2500 pps |
| Peakstrom (>250 ns) | 1.800 bis 5.500 A |
| Umkehrstrom (>200 ns) | 40 % des Peakstroms |
| Stromanstieg | 120 -500 A/ns |

Die bekannten Hochleistungsschaltmodule arbeiten mit den verschiedensten aktiven Bauelementen. Bei mit Wasserstoff oder Deuterium gefüllten Thyratrons werden kurze Schaltzeiten bei hohen Spannungen und Strömen erreicht. Problematisch sind die sehr großen mechanischen Abmessungen und eine notwendige ständige Heizung, die Vorwärmzeiten erforderlich macht. Weitere Nachteile sind eine endliche Lebensdauer durch Wasserstoffverlust und eine Kathodenermüdung.

Bei primärseitig geschalteten Hochleistungsschaltmodulen mit Halbleiterschaltsystemen wird der Schaltvorgang mit Spannungen ausgeführt, die mit heute verfügbaren Halbleiterbauelementen sicher beherrscht werden (1 bis 1,5 kV). Ein hochfrequenter Pulstreiber transformiert den Schaltvorgang in den benötigten Hochspannungsbereich von einigen 10 kV. Nachteilig sind hier die endliche Bandbreite derartiger Pulstreiber, die großen Baumaße, extrem hohe Ströme auf der Primärseite und ein schlechter Wirkungsgrad. Weiterhin muss in der Regel der HV-Impuls nachversteilert werden. Für die Applikationen, auf die die Erfindung zielt, sind derartige Schaltsysteme deshalb nicht einsetzbar.

Weiterhin existieren neuerdings auf dem Markt Hochleistungsschaltmodule mit so genannten "Plasmahalbleiterschaltern" (Drift Step Recovery Diodes (DSRD) oder Fast Ionisation Dynistors ( FID ) als ein- und mehrstufige Halbleiterschalter mit besonderen Ausführungen (vergleiche Publikation "High Power Semiconductor-Based Nano and Subnanosecond Pulse Generator with a Low Delay Time" von I.V. Grekhov et al. aus IEEE Transactions on Plasma Science, Vol.33, No.4, August 2005, pp 1240-1244). Jedoch gibt es zu diesen Halbleiterschaltern noch keine gesicherten Angaben zur Zuverlässigkeit und Lebensdauer, was den derzeitigen Einsatz in Industrieprodukten erheblich erschwert. Diese Bauelemente sind prinzipiell nicht abschaltbar, wodurch sie für einige Anwendungen nicht in Frage kommen.

Am häufigsten werden bislang direkt schaltende Leistungsmodule mit Bipolar- und Unipolar-Schaltransistoren sowie IGBT's eingesetzt. Die Strom- und Spannungsbereiche, die bei der vorliegenden Erfindung betrachtet werden, machen hierbei jedoch bislang die Reihen- und Parallelschaltung von einigen hundert Bauelementen erforderlich. Zum Ausgleich von Bauelementetoleranzen werden deshalb Symmetriemetzwerke erforderlich. Ab ca. 300 Bauelementen führen die Eigenschaften dieser Symmetriemetzwerke (Limitierung von Dynamik, Toleranzen, Verlustleistung) jedoch dazu, dass die Parameter der Halbleiterschalter nicht mehr annähernd voll ausgeschöpft werden können. Die Schaltgeschwindigkeit oder Stromanstiegsgeschwindigkeit eines derart aufgebauten Schaltungsmoduls ist nicht mehr steigerbar, die Verlustleistung derartiger Systeme steigt in unwirtschaftliche Bereiche.

Bei den bekannten Hochleistungsschaltmodulen werden genügend hohe Spannungen im Bereich einiger 10 kV und Schaltzeiten unter 20 ns nur erreicht durch Reihenschaltungen vieler Einzelschalter (vergleiche US 4.425.518). Die Einzelschalter müssen jedoch möglichst zeitsynchron angesteuert werden, wie es in der DE 36 30 775 C2 durch einen gestuften Trafo gelöst wird. Zur Steigerung des zulässigen Stromes ist auch eine Matrixanordnung vieler Leistungsschalter bekannt (vergleiche DE 696 29 175 T2).

Damit können nur Ströme bis zu wenigen 100 A sicher beherrscht werden. Um bei hohen Spannungen in den Grenzbereichen der Bauelemente eine gleichmäßige Verteilung der Spannung auf die einzelnen Stufen bei etwas unterschiedlichen aktiven Bauelementen zu erreichen, wird in der DD 234 974 A1 eine Kette von Widerständen parallel zu den Schaltstufen geschaltet. In der DE 198 25 056 C1 wird eine Schaltungsanordnung zum Einspeisen von Elektroenergie in ein Plasma einer Glimmentladung mit einer speziell zusammengeschalteten p- und n-leitenden MOSFET-Endstufe als Treiber für einen Hochleistungs-IGBT beschrieben, um die Leistung unipolar oder bipolar gepulster Plasmen erhöhen zu können.

Aus der DE 36 30 775 C2 ist ein Hochleistungsschaltmodul bekannt, bei dem mehrere Schaltstufen jeweils einen MOSFET als Halbleiterschalter aufweisen. Alle Halbleiterschalter sind mit ihren Anoden- und Kathodenanschlüssen in Reihe geschaltet. In jeder Schaltstufe ist ein Steuemetzwerk für den Halbleiterschalter vorgesehen, das zwischen dem Steueranschluss und einem Pulstreiber, der mit einer Primär- und einer der Anzahl der vorgesehenen Schaltstufen entsprechenden Anzahl von Sekundärwicklungen ausgerüstet ist, angeordnet ist. Ohne dieses Ansteuemetzwerk ist die Schaltdauer des bekannten Hochleitungsschaltmoduls durch die Spannungszeitfläche des Pulstreibers fest vorgegeben und liegt in der Größenordnung von 100 ns. Zur Erzielung von geringfügig längeren Schaltdauern weist das Steuemetzwerk deshalb eine Steuerdiode, die bezüglich der induzierten Steuerspannung in Durchlassrichtung gepolt ist, und einen Steuerwiderstand, der zwischen den Steuer- und den Anodenanschluss der Halbleiterschalters geschaltet ist, auf. Bei dem bekannten Hochleistungsschaltmodul dient das Ansteuemetzwerk also einer möglichen Verlängerung der Schaltdauer in Abhängigkeit eines fest eingestellten Steuerwiderstands pro Schaltstufe.

Der nächstliegende Stand der Technik, von dem die vorliegende Erfindung ausgeht, wird in der DE 195 15 279 C2 offenbart. Bei diesem gattungsgemäßen Hochleistungsschaltmodul sind parallel zu jedem Halbleiterschalter zwischen Anoden- und Kathodenanschluss eine Snubberkapazität und ein zusätzlicher Synchronisierwiderstand (dort als Varistor) geschaltet. Snubbernetzwerke neutralisieren störende Schwingungen oder Spannungsspitzen. Die beim Prellen der Kontakte des Halbleiterschalters entstehenden hochfrequenten Spannungsspitzen werden durch eine Snubberkapazität kurzgeschlossen. Werden in die Schaltstufe Schaltpulse vom Pulstreiber induziert, so gelangen diese über die Steuerdiode an den Steueranschluss des Halbleiterschalters, laden dessen Snubberkapazität auf und der Halbleiterschalter schaltet ein. Bei nachlassender Pulsamplitude verhindern die dann gesperrten Steuerdioden einen Ladungsausgleich in der Snubberkapazität über den Pulstreiber, sodass die Snubberkapazität nur durch den parallel geschalteten Steuerwiderstand entladen wird. Die Schaltdauer kann somit durch den Wert des Steuerwiderstandes eingestellt werden.

Dabei besteht jedoch bei diesem bekannten und bei allen genannten Hochleistungsschaltmodulen immer eine feste Bindung jeder Schaltstufe an einen Arbeitspunkt mit einer festen Schaltstufenspannung. Bauelementetoleranzen und Betriebsschwankungen lassen deshalb nur eine Schaltsynchronität bestenfalls zwischen 3 ns und 5 ns zu. Wenn aber durch Arbeitspunktverschiebungen, Temperaturgang oder Störeinkopplungen einzelne Schaltstufen eher als andere einschalten, kann dies zur Zerstörung aller Halbleiterschalter im Hochleistungsschaltmodul führen. Dies gilt im gleichen Maß auch für Ausschaltvorgänge. Wenn aktiv ausgeschaltet wird, muss dies zwangsweise synchron erfolgen, da sonst die Spannung an der zuerst schaltenden Schaltstufe unzulässig ansteigt und die Schaltstufe zerstört wird.

Die Schaltsynchronität in einem Hochleistungsmodul wird durch die Ein- und Ausschaltzeitkonstanten (tum on delay, tum off delay) der einzelnen Schaltstufen bestimmt. Diese werden wiederum von den Bauelementeparametern, beispielsweise Snubberkapazität, Schaltpegel, Verstärkung, Linearität und Mitkopplung, beeinflusst. Hinzu kommen noch Einflüsse der Schalterperipherie wie Steuerpegel, Quellwiderstand, Anoden- und Kathodenspannung, Lastkapazität- und induktivität sowie der Temperaturgang. Bei den bekannten Hochleistungsschaltmodulen im Stand der Technik werden Unterschiede in den Schaltzeiten der einzelnen Halbleiterschalter durch innere Mitkoppeleffekte ausgeglichen und durch äußere Schutzbeschaltungen begrenzt. Durch die trotzdem noch stark variierenden Ein- und Ausschaltzeitkonstanten der einzelnen Schaltstufen kann jedoch bei bekannten Hochleistungsmodulen keine Schaltsynchronität im unteren ns-Bereich erreicht werden.

Die Aufgabe für die vorliegende Erfindung ist daher darin zu sehen, ein gattungsgemäßes Hochleistungsschaltmodul der eingangs genannten Art so weiterzubilden, dass auch bei extremen Betriebsbedingungen eine hohe Schaltsynchronität unterhalb von 1,5 ns aller Schaltstufen beim Ein- und Ausschalten über einen weiten Spannungs- und Temperaturbereich gewährleistet ist. Dazu sind die Ein- und Ausschaltzeitkonstanten aller Schaltstufen auf gleiche Werte im ns-Bereich zu bringen und auch unter den extremen Betriebsbedingungen zu halten. Die Mittel zur Lösung dieser Aufgabe sollen einfach in der Handhabung, robust im Betrieb und kostengünstig in der Anschaffung sein. Weiter ist es Aufgabe für die vorliegende Erfindung, ein auf das weitergebildete Hochleistungsmodul abgestimmtes Verfahren zur Erzielung einer hohen Schaltsynchronität anzugeben, wobei auch das Verfahren einfach, robust und kostengünstig sein soll. Die Lösungen für diese Aufgaben sind dem Produktanspruch und dem nebengeordneten Verfahrensanspruch zu entnehmen. Vorteilhafte Modifikationen werden jeweils in den Unteransprüchen aufgezeigt und im Folgenden im Zusammenhang mit der Erfindung näher erläutert.

Das erfindungsgemäße Hochleistungsschaltmodul ist vornehmlich **dadurch gekennzeichnet, dass** in jeder Schaltstufe in Abhängigkeit von den individuellen Gegebenheiten der Arbeitspunkt, also das eigentliche Schaltereignis, in seiner zeitlichen Lage veränderlich einstellbar ist. Diese veränderliche Einstellbarkeit basiert auf der grundlegenden Erkenntnis, dass bei einer in parallelen Schaltstufen erfolgenden Kaskadierung moderner Leistungsbauelemente deren maximal mögliche Schaltzeiten (Ein- und Ausschalten) nur nutzbar sind, wenn alle Schaltzeitpunkte in ein gemeinsames Zeitfenster geschoben werden. Die Breite des Zeitfensters bestimmt damit die Schaltsynchronität und kann beispielsweise unterhalb von 1,5 ns liegen.

Zur schaltstufenindividuellen Verschiebung der Schaltzeitpunkte weist das Steuemetzwerk ein mit der Steuerdiode in Reihe und zum Steuerwiderstand parallel geschaltetes einstellbares Verzögerungselement auf, mit dem eine schaltstufenindividuelle Offsetspannung am Halbleiterschalter zur variablen Einstellung seiner Ein- und Ausschaltpunkte eingestellt werden kann.
Mit dem Verzögerungselement können folgende Effekte im Hochleistungsschaltmodul nach der Erfindung kompensiert werden:
■ individuelle Toleranzen der Schaltverzögerungszeit zwischen den einzelnen Halbleiterschaltern, bedingt durch
   ○ Grenzen der Reproduzierbarkeit der inneren Halbleiterstrukturen, die sich im Toleranzfeld der Schaltverzögerungszeit widerspiegeln
   ○ Toleranzen im Zusammenspiel zwischen der Ansteuerelektronik und dem Steueranschluss der Halbleiterschalter durch Snubberkapazitäten und Ansprechschwellen
■ systematische temperaturabhängige Abweichungen, bedingt durch einen bekannten Temperaturgradienten zwischen den einzelnen Schaltstufen, d.h. die vorgesehene Wärmesenke wirkt nicht absolut gleichmäßig auf jede Schaltstufe
■ individuelle Toleranz der Kathoden-/Kollektor-/Anodenspannung einer jeden Schaltstufe, bedingt durch Ungenauigkeiten des symmetrisierenden Netzwerks von Synchronisierwiderständen
■ eventuell individuelle Streuungen der Abhängigkeiten zwischen Schaltverzögerungszeit und Anodenspannung bzw. Temperatur.

In Abhängigkeit vom jeweils langsamsten Halbleiterschalter beim Ein- bzw. Ausschalten werden bei dem Hochleistungsmodul nach der Erfindung alle anderen Halbleiterschalter in ihrer Ein- bzw. Ausschaltdauer gezielt so verzögert, dass alle Halbleiterschalter in einem sehr engen Zeitfenster unterhalb von 1,5 ns schalten. Zum verzögerten Schalten jedes Halbleiterschalters werden weiterhin bei der Erfindung eine bezüglich ankommender Schaltpulse in Sperrichtung gepolte Hilfsdiode und eine Hilfskapazität zur Auskopplung und Speicherung von Hilfsenergie zum Halten der schaltstufenindividuellen Offsetspannung am Halbleiterschalter eingesetzt.

Da die Ein- und Ausschaltzeiten der bekannten Halbleiterschalter derzeit nicht unter 1 ns reduzierbar sind und große Bauelementabweichungen auftreten, werden bei der Erfindung durch die Verzögerung der Ein- und Ausschaltzeitdauern die Endpunkte der Ein- und Ausschaltvorgänge mit dem Ergebnis des vollständig ein- oder ausgeschalteten Halbleiterschalters in ein sehr schmales Zeitfenster unter 1,5 ns gelegt, sodass sich die geforderte hohe Schaltsynchronität sowohl für den Ein- als auch für den Ausschaltzustand ergibt. Durch die erreichte hohe Schaltsynchronität beim Ein- und Ausschalten kann in Folge die Schaltzeit (rise time) des Hochleistungsschaltmoduls gegenüber bekannten Modulen bedeutsam erhöht werden. Durch diese Maßnahmen kann die Pulsenergie so effizient geschaltet werden, dass bereits 10 bis maximal 20 Leistungsbauelemente das für die meisten Anwendungen erforderliche Leistungsprofil erbringen. Gegenüber Lösungen mit bis zu 300 Halbleiterschaltern, wie aus dem Stand der Technik bekannt, stellt dies eine deutliche Verringerung der erforderlichen Anzahl von Halbleiterschaltern und damit der Kosten dar.

Zur Erreichung der hohen Schaltsynchronität wird am Halbleiterschalter jeder Schaltstufe im erfindungsgemäßen Hochleistungsmodul in einem aktiven oder passiven Ansteuemetzwerk eine individuelle Offsetspannung voreingestellt. Da die einzelnen Ein- und Ausschaltzeiten der Halbleiterschalter von den dauerhaften und den momentanen Betriebsbedingungen in jeder Schaltstufe abhängen, ist im Ansteuemetzwerk ein Verzögerungselement vorgesehen, über das die schaltstufenindividuelle Offsetspannung in einem ausreichend weiten Bereich durch unterschiedliche Verzögerung kontinuierlich eingestellt werden kann. Fallabhängig kann dieses Verzögerungselement eine passive Kompensationsschleife oder eine aktive Regelschleife und Messvorrichtungen zur Messung der momentanen Schaltstufenspannung und der momentanen Schaltstufentemperatur umfassen.

Als weitere Maßnahmen für eine Optimierung der Schaltsynchronität werden bekanntermaßen noch in jeder Schaltstufe eine Snubberkapazität und ein zusätzlicher Synchronisierwiderstand parallel zum Halbleiterschalter zwischen Anoden- und Kathodenanschluss geschaltet. Die parallel geschalteten Snubberkapazitäten sorgen für eine dynamische Spannungsaufteilung in der Schaltphase und speisen die Halbleiterschalter in den sicher geschalteten Zustand. Die negative Wirkung von Zuleitungsinduktivitäten, die beim Schalten durch Einschwingverläufe den Haltestrom der Schaltstufen unterschreiten lässt, können wirksam unterdrückt werden. Die in jeder Schaltstufe beigefügten Synchronisierwiderstände parallel zum Halbleiterschalter sorgen für eine gleichmäßige Spannungsaufteilung auf alle Schaltstufen.

In einer Modifikation des erfindungsgemäßen Hochleistungsschaltmoduls kann vorgesehen sein, dass die Einschaltdiode für vorgegebene Offsetspannungswerten auch in der Sperrrichtung bezüglich der ankommenden Schaltpulse durchlässig ist. Eine beidseitig spannungsabhängig durchlässige Einschaltdiode kann zum einen den für den Schaltvorgang des Halbleiterschalters erforderlichen Schaltstrom sicher durchlassen und einen Rückstrom verhindern, zum anderen kann sie aber auch in der Gegenrichtung einen geringeren Strom, der beispielsweise Überwachungszwecken dient, durchlassen. Näheres hierzu ist ebenfalls den Ausführungen zum Verfahren nach der Erfindung zu entnehmen.

Ein weiteres Modifikationspaket des Hochleistungsmoduls nach der Erfindung beschäftigt sich mit dessen Betriebstemperatur. Die momentane Temperatur in den einzelnen Schaltstufen hat einen wesentlichen Einfluss auf das Schaltverhalten der Halbleiterschalter und somit auf die Einstellung der schaltstufenindividuellen Offsetspannung bzw. der verzögerten Schaltzeit. Somit ist für einen guten Temperaturausgleich zwischen den einzelnen Schaltstufen und für eine insgesamt möglichst konstante Temperatur aller Schaltstufen zu sorgen. Vorteilhaft ist es deshalb, wenn die einzelnen Schaltstufen auf einen gemeinsamen Träger aus einem Basismaterial mit sehr hoher Wärmeleitfähigkeit aufgebracht sind. Hierbei kann es sich bevorzugt um ein technisches Keramikmaterial, beispielsweise Aluminiumoxid oder Aluminiumnitrid, handeln. Aus dem Stand der Technik ist eine Vielzahl von technischen Keramiken mit sehr hohen Wärmeleitkoeffizienten bekannt. Für die im passiven Netzwerk enthaltenen Bauelemente bietet sich die Dickschichttechnologie an. Diese Technologie ermöglicht die Konstruktion selbstkompensierender Schaltungen, präzise Abgleichmöglichkeiten und hohe Zuverlässigkeit.

In der konstruktiven Gestaltung kann das Hochleistungsmodul planar, d.h. zweidimensional in der Fläche, oder räumlich, d.h. dreidimensional im Raum, ausgebildet sein. Dabei gewährleistet der Aufbau einen minimalen Temperaturgradienten (unter 10 K) zwischen den Schaltstufen, ideale Verlustleistungsabführung (einige 100 Watt), minimalen Platzbedarf und damit einhergehend geringste mögliche Baugruppeninduktivität. Dies ist angesichts der betrachteten Schaltzeiten ein besonderer Vorteil. Bei der planaren Ausbildung sind alle Schaltstufen auf einem gemeinsamen Träger angeordnet. Dies ermöglicht eine ideal angepasste Geometrie und eine hohe Spannungsfestigkeit und Stabilität. Bei der räumlichen Ausbildung wird einer oder einer Gruppe von Schaltstufen ein eigener Träger zugeordnet. Alle Träger werden dann über- oder nebeneinander in einen Rahmen aus einem Material mit hoher Wärmeleitfähigkeit eingesteckt. Um einen Temperaturausgleich zwischen den einzelnen Trägem zu gewährleisten, kann bevorzugt der Rahmen aus einem elektrisch leitenden oder elektrisch isolierenden Material ausgebildet sein. Es kann sich beispielsweise um einen Metallrahmen handeln. Dabei kann der Rahmen an eine Kühleinrichtung des Verbrauchers thermisch angekoppelt sein, um die auftretende Wärmelast einfach abführen zu können. Bei der Kühleinrichtung kann es sich beispielsweise um den Kühlkollektor eines Gasentladungslasers handeln.

Die Realisierung der Bauelemente auf einem gemeinsamen Träger in einem Prozess, gekoppelt mit dem aktiven Abgleich der einzelnen Schaltstufen durch eine individuelle Offsetspannungseinstellung bei dem Hochleistungsschaltmodul nach der Erfindung, ermöglichen enge Bauelementetoleranzen und einen hohen Gleichlauf (TK, Spannungsabhängigkeit u.a.)

Bereits weiter oben wurde ausgeführt, dass die Ein- oder Ausschaltzeiten eines Hochleistungsschaltmoduls durch individuelle Betriebsbedingungen nicht unter 1 ns verkürzbar sind. Dabei handelt es sich bereits um ultrakurze Schaltzeiten, die aber auch nur Schaltfenster von 3 bis 5 ns erbringen. Das aus der DE 36 30 775 C2 bekannte Hochleistungsschaltmodul hat noch eine Schaltzeit von 100 ns, ist aber auch schon zwanzig Jahre alt. Da es aber zur Erzeugung beispielsweise von ultrakurzen Lichtpulsen (im ps-Bereich) mit einem Gasentladungslaser wichtig ist, dass die gesamte gespeicherte Energie vom Hochleistungsschaltmodul in einem sehr schmalen Zeitfenster - angestrebt wird eine Breite von 800 ps - freigegeben wird und auch der Ausschaltvorgang in einem derart schmalen Zeitfenster erfolgt, damit eine hohe Pulsfotgefrequenz erreicht werden kann, basiert das erfindungsgemäße Hochleistungsschaltmodul auf dem Grundgedanken, jeden einzelnen Halbleiterschalter in seiner Schaltzeit individuell einzustellen und auf ein Zeitfenster unterhalb von 1,5 ns zu trimmen.

Somit ist ein bevorzugtes Verfahren zur Erzeugung von Schaltsynchronität bei einem Hochleistungsschaltmodul der beschriebenen Art **dadurch gekennzeichnet, dass** in jeder Schaltstufe am Halbleiterschalter unter Ausnutzung von gespeicherter Hilfsenergie eine schaltstufenindividuelle Offsetspannung zur Verzögerung der Schaltzeit eingestellt wird, deren Wert in Abhängigkeit von der gesamten Schaltstufenkapazität, der momentanen Schaltstufenspannung und der momentanen Schaltstufentemperatur so bestimmt wird, dass die Halbleiterschalter aller Schaltstufen nach dem Eintreffen eines Schaltpulses in einem Zeitfenster ≤ 1,5 ns eingeschaltet sind. Dabei wird in jeder Schaltstufe die Hilfsenergie mittels eines den Schaltpulsen des Pulstreibers überlagerten Wechselstroms vom Pulstreiber abgezweigt. Mit diesem Verfahren werden in jeder Schaltstufe individuell die aktuellen Schaltbedingungen des Halbleiterschalters ermittelt und berücksichtigt, indem eine individuelle Offsetspannung mit der Wirkung einer verzögernden Biasspannung am Halbleiterschalter eingestellt wird. Diese Offsetspannung richtet sich nach dem jeweils langsamsten Halbleiterschalter und sorgt für eine entsprechende Verzögerung aller anderen Halbleiterschalter. Je negativer die Offsetspannung voreingestellt ist, desto später geht der Halbleiterschalter in den sicher ein- oder ausgeschalteten Zustand über. Der schnellste Halbleiterschalter im Verbund erhält somit den größten Betrag an Offsetspannung als Voreinstellung. Die Hilfsenergie wird dabei dazu genutzt, die Offsetspannung am Halbleiterschalter aufzubauen und diesen in einem sicheren offenen Zustand zu halten.

Dabei kann bevorzugt die Einstellung der Offsetspannung bezüglich des gesamten Schaltstufenpotenzials als Grundwert (statisch) und bezüglich der momentanen Schaltstufenspannung und der momentanen Schaltstufentemperatur als Momentanwert (dynamisch) in einer passiven Kompensationsschleife, wie sie aus der Messtechnik hinreichend bekannt ist, oder in einer aktiven Regelschleife erfolgen. Das dabei erforderliche aktive Regelelement bezieht seine Energie dann aus der in der Schaltstufe zur Verfügung gestellten Hilfsenergie. Die Schaltzeitkonstante jeder Stufe (tum on delay, turn off delay) wird von Snubberkapazität, Schaltpegel, Verstärkung, Linearität und Mitkopplung des Leistungsbauelements bestimmt. Toleranzen dieser Parameter führen, auch bei exakt abgestimmten Treiberpulsen, zu unterschiedlichen Schaltzeitpunkten. Bei der Erfindung werden die Toleranzen über einen individuell einstellbaren Offsetgrundwert ausgeglichen. Hinzu kommen die Einflüsse der Schalterperipherie wie Steuerpegel, Quellwiderstand, Anoden-Kathodenspannung, Lastkapazität- und Induktivität sowie der Temperaturgang je Stufe. Erfindungsgemäß werden die von den momentanen Betriebsbedingungen abhängigen Delayverschiebungen jeder Schaltstufe dem Offsetgrundwert derart aufgeschaltet, dass ein Schaltzeitfenster von < 1,5 ns über alle Schaltstufen erhalten wird und bleibt.

Schließlich kann bei dem Verfahren als Weiterbildung noch vorteilhaft vorgesehen sein, dass die schaltstufenindividuelle Offsetspannung durch Vergleich mit einem vorgegebenen Grenzwert gleichzeitig zur Funktionsüberwachung jeder Schaltstufe eingesetzt und in verknüpfter Form zur Freigabe der Treiberschaltung eingesetzt wird. Somit können durch die ständig wiederholte Ermittlung der Offsetspannung auch Kontrollfunktionen für die Betriebssicherheit des gesamten Hochleistungsschaltmoduls übernommen werden. Dabei wird von vorgegebenen minimalen und maximalen Grenzwerten ausgegangen, zwischen denen die eingestellte Offsetspannung liegen darf. Werte außerhalb dieser Grenzwerte deuten auf eine fehlerhafte Schaltstufe hin. Liegt die eingestellte Offsetspannung aber im erlaubten Bereich, kann diese über die dann in beide Richtungen entsprechend teildurchlässige Einschaltdiode an den Treiber weitergeleitet werden. Somit kann sichergestellt werden, dass die Schaltstufen immer nur dann geschaltet werden, wenn sichere Betriebsbedingungen vorliegen. Bei Abweichungen wird ein Fehlersignal generiert und /oder der Schaltpuls gesperrt, wodurch Sekundärausfälle verhindert werden.

Das Hochleistungsschaltmodul nach der Erfindung und ein bevorzugtes Verfahren zur Erzeugung von Schaltsynchronität bei einem derartigen Hochleistungsschaltmodul werden nachfolgend in Ausführungsbeispielen, anhand der schematischen Figuren, beispielhaft näher erläutert. Dabei zeigt:
- Figur 1: einen Schaltplan des Hochleistungsschaltmoduls,
- Figur 2: eine Steuerspannungskurve eines Halbleiterschalter,
- Figur 3: einen Querschnitt durch ein planares Hochleistungsmodul und
- Figur 4: einen Querschnitt durch ein räumliches Hochleistungsmodul.

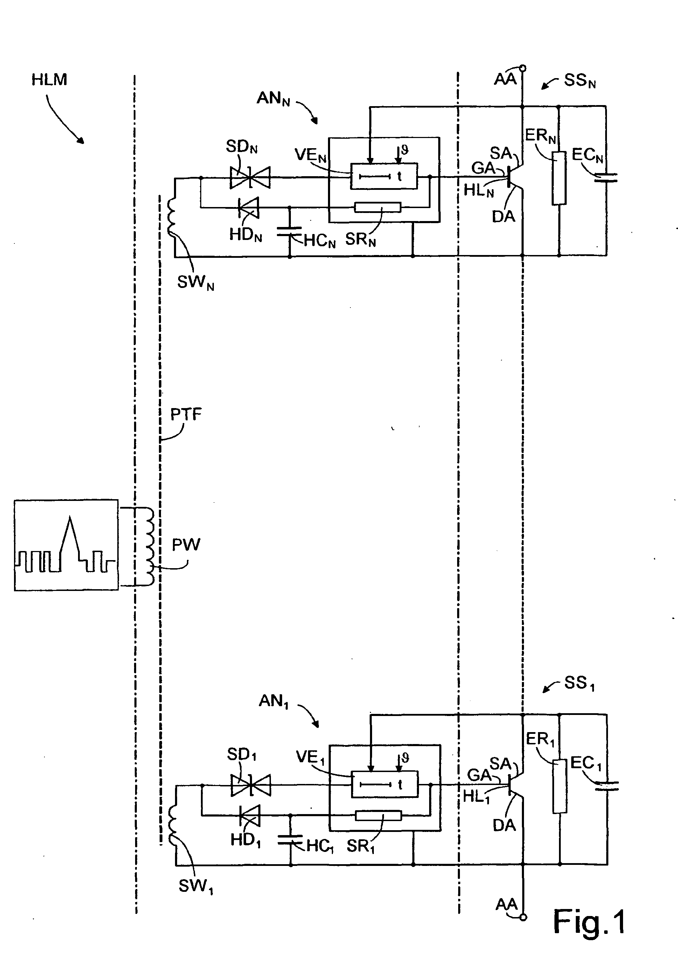

In der Figur 1 ist ein Hochleistungsschaltmodul HLM nach der Erfindung zur direkten Pulsenergieeinspeisung eines Verbrauchers dargestellt. Bei dem Verbraucher kann es sich um einen transversal elektrisch angeregten Gasentladungslaser zur Erzeugung von ultrakurzen Lichtpulsen handeln. Die zur Lichtverstärkung benötigte Energiezuführung wird dabei durch eine Hochstromentladung mit 1.000 -14.000 A cm⁻² quer durch das aktive Laservolumen erreicht. Durch die Hochstromentladung wird in der Gasentladungsstrecke ein Plasma gezündet. Gespeist wird die Hochstromentladung beispielsweise aus niederinduktiven Kondensatoren, in denen in den Laserpulspausen Elektroenergie zwischengespeichert wird. Über das Hochleistungsmodul HLM wird die zwischengespeicherte Energie beispielsweise mit einer Stromanstiegsgeschwindigkeit von beispielsweise 100.000 A/µs in das Laservolumen zur Plasmazündung geleitet. ( z.B. LTB MNL 100 )

Das Hochleistungsschaltmodul HLM besteht aus einer Anzahl N von Schaltstufen SS_{N}, beispielsweise N= 1....10 bis max. 20, die jeweils einen Halbleiterschalter HL_{N} mit einem Anodenanschluss SA (auch Quellen- oder Anodenanschluss), einem Kathodenanschluss DA (auch Senken- oder Kathodenanschluss) und einem Steueranschluss GA (Steuerung) aufweisen. Bei dem Halbleiterschalter HL kann es sich um einen MOS gesteuerten Thyristor (MCRT) oder um einen SMCT handeln. Jedem Halbleiterschalter HL_{N} sind eine Snubberkapazität EC_{N} und ein Synchronisierwiderstand ER_{N} zwischen Anodenanschluss SA und Kathodenanschluss DA parallel geschaltet. Alle Halbleiterschalter HL_{N} sind mit ihren Anodenanschlüssen SA und Kathodenanschlüssen DA in Reihe geschaltet. An äußeren Anschlüssen AA ist der Verbraucher angeschlossen. Weiterhin weist jedes Hochleistungsschaltmodul HLM ein Ansteuernetzwerk AN_{N} zur individuellen Einstellung des Ein- und Ausschaltzeitpunktes jedes Halbleiterschalters HL_{N} durch eine Offsetspannung auf. Über das Ansteuemetzwerk AN_{N} ist jede Schaltstufe SS_{N} mit einem Pulstreiber PTF als Triggerquelle verbunden. Dieser weist eine allen Schaltstufen SS_{N} gemeinsame Primärwicklung PW auf, der für jede Schaltstufe SS_{N} eine Sekundarwicklung SW_{N} zugeordnet ist. So können alle Schaltstufen SS_{N} gemeinsam von dem Pulstreiber PTF versorgt werden.

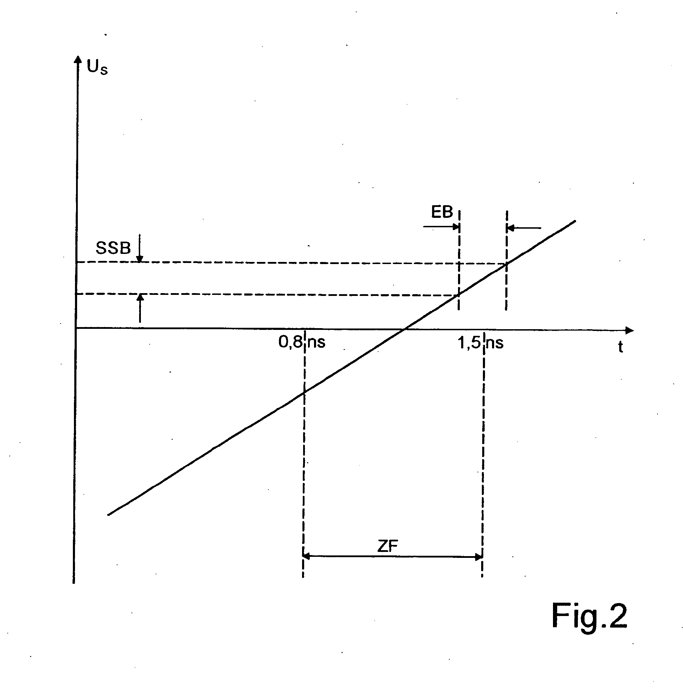

Jedes Ansteuemetzwerk AN_{N} pro Schaltstufe SS_{N} weist eine Steuerdiode SD_{N} als Potenzialsperre auf, über die nur ein ausreichend großer Schaltpuls des Pulstreibers PTF auf den Halbleiterschalter HL_{N} durchgelassen wird. In Reihe zu der Steuerdiode SD_{N} ist ein Verzögerungselement VE_{N} angeordnet, über das eine Offsetspannung am Halbleiterschalter HL_{N} und damit dessen Schaltzeit in weiten Bereichen und in Abhängigkeit von den momentanen Umgebungsbedingungen eingestellt wird (zur Einstellung der Offsetspannung siehe Figur 2). Parallel zur Steuerdiode SD_{N} und dem Verzögerungselement VE_{N} ist jeweils noch ein Steuerwiderstand SR_{N} angeordnet. Die eingestellte Offsetspannung wird am Halbleiterschalter HL_{N} durch eine Hilfsenergie, die in einer Hilfskapazität HC_{N} gespeichert wird, sicher im Sperrzustand gehalten. Die Hilfsenergie wird über eine Hilfsdiode HD_{N} vom Pulstreiber PTF abgezweigt. Dafür wird dieser mit einer kleinen Wechselspannung, beispielsweise Sinus-, Dreieck- oder Rechteckverlauf, beaufschlagt, die dem Triggern der Schaltpulse (Potenzialdifferenz einige 10 kV) dem Pulstreiber PTF überlagert wird (vergleiche Einschub Figur 1).

In der Figur 2 ist ein schematisches Diagramm zum Einstellverhalten jedes Halbleiterschalters HL_{N} pro Schaltstufe SS_{N} dargestellt (gezeigt ist nur der Einschaltvorgang, für den Ausschaltvorgang gilt aber Analoges, hier mit einer fallenden Ansteuergeraden). Aufgetragen ist die Steuerspannung U_{S} über der Zeit t. Der Halbleiterschalter HL_{N} besitzt ein lineares Schaltverhalten. Der gestrichelte Bereich zeigt den sicheren Schaltbereich SSB jedes Halbleiterschalters HL_{N}. Dieser muss von allen Halbleiterschaltern HL_{N} des Hochleistungsschaltmoduls HLM innerhalb eines Zeitfensters ZF von maximal 1,5 ns (angestrebt wird eine minimale Breite von nur ca. 600 bis 800 ps) erreicht werden. Je nach Betriebszustand der jeweiligen Schaltstufe SS_{N} haben die Halbleiterschalter HL_{N} jedoch eine unterschiedliche Schaltdauer. Damit alle Halbleiterschalter HL_{N} synchron schalten, wird zunächst der langsame Halbleiterschalter HL_{N} ermittelt. Alle anderen, schnelleren Halbleiterschalter HL_{N-1} werden dann entsprechend ihrer eigenen Schaltdauern zu diesem Halbleiterschalter HL_{N} durch Einstellen einer Offsetspannung verzögert. Je schneller der Halbleiterschalter HL_{N-1}, desto größer muss die voreingestellte Offsetspannung sein, desto größer wird die erreichte Verzögerung. Alle Halbleiterschalter HL_{N} können in einem Einstellbereich EB bis zu einer maximalen Offsetspannung und damit mit einer maximalen Verzögerung voreingestellt werden. Höhere erforderliche Offsetspannungen deuten auf eine Funktionsstörung des Halbleiterschalters HL_{N} hin.

Die einzustellende Offsetspannung hängt zum einen von den Bauelementeparametern in der jeweiligen Schaltstufe SS_{N} ab. Hierbei handelt es sich um einen Grundwert, der zu einer ersten Offsetspannung führt. Weiterhin überlagern sich am Halbleiterschalter HL_{N} momentane Betriebszustände. Hierbei handelt es sich um die momentane Schaltstufenspannung und die momentane Schaltstufentemperatur. Diese beiden Werte, die mit entsprechenden Messeinrichtungen gemessen werden, überlagern sich mit dem Grundwert der Offsetspannung. Beide Werte führen dann zu einer individuellen und zeitabhängigen Voreinstellung jedes Halbleiterschalters HL_{N}. Im Ausschaltzustand wird der Halbleiterschalter HL_{N} durch Nutzen einer Hilfsenergie im sichereren Sperrbereich gehalten. Nach der Auslösung eines Schaltpulses schalten dann alle Halbleiterschalter HL_{N} individuell durch die zusätzliche Verzögerung mit einer solchen Dauer, dass sie ihren sicheren Schaltbereich SSB (für Ein- und Ausschalten) innerhalb des gemeinsamen vorgegebenen Zeitfensters ZF unterhalb von 1,5 ns erreicht haben. Dadurch kann bei dem Hochleistungsschaltmodul HLM nach der Erfindung ein besonders hoher Stromanstieg erreicht werden.

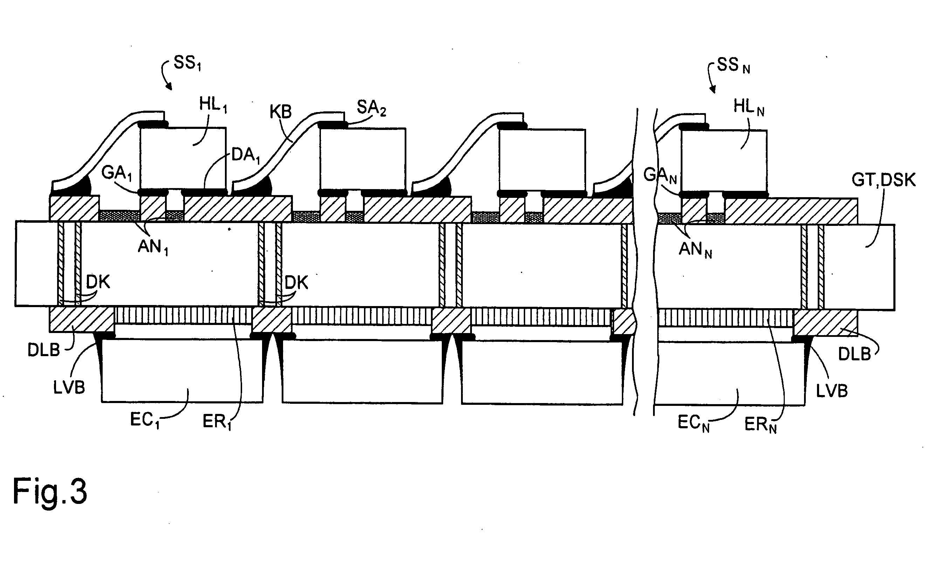

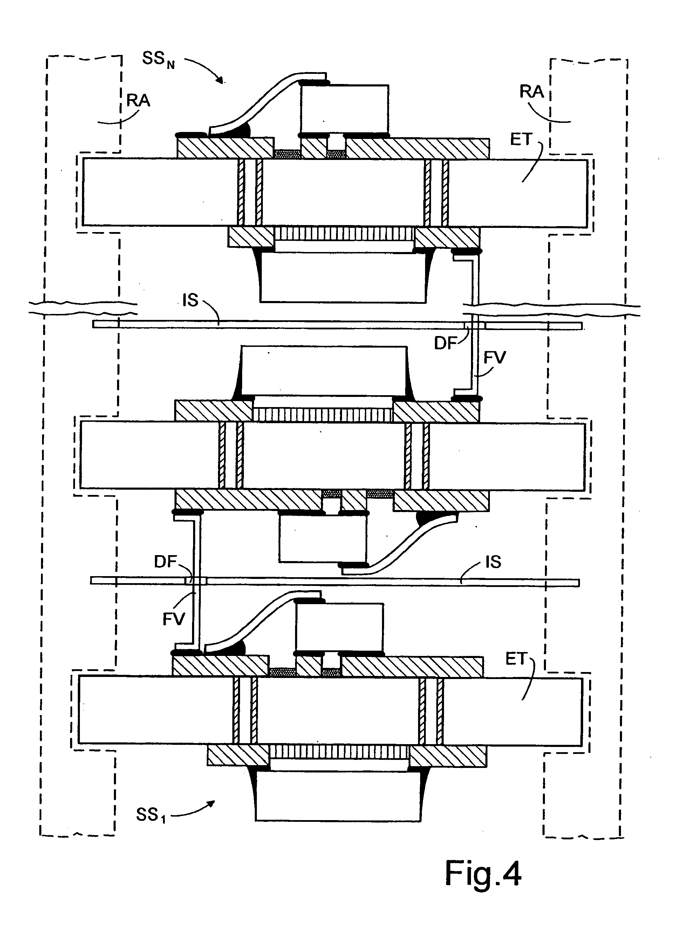

In den Figuren 3 und 4 ist das Hochleistungsschaltmodul HLM nach der Erfindung in einer planaren Ausführung (Figur 3) und in einer räumlichen Ausführung (Figur 4) dargestellt.

In der planaren Ausführungsform gemäß Figur 3 sind alle Schaltstufen SS_{N} (mit N von 1 bis i bei i vorgesehenen Schaltstufen SSᵢ) auf einem gemeinsamen Träger GT angeordnet. Im gezeigten Ausführungsbeispiel handelt es sich dabei um eine Dickschichtkeramik (DSK). Auf der Oberseite des gemeinsamen Trägers GT sind die Halbleiterschalter HL_{N} angeordnet. Die Kathodenanschlüsse DA_{N} sind mit den Anodenanschlüssen SA_{N} benachbarter Halbleiterschalter HL_{N} über Kontaktbügel KB in Reihe geschaltet. Auf der Unterseite der Halbleiterschalter HL_{N} sind die Steueranschlüsse GA_{N} mit den Ansteuemetzwerken AN_{N} verbunden. Die Schaltung der einzelnen Ansteuernetzwerke AN_{N} ist der Figur 1 zu entnehmen. Weiterhin sind über Durchkontaktierungen DK, Dickschichtleiterbahnen DLB und elektrisch leitende Lötverbindungen LVB die Snubberkapazitäten EC_{N} und die Synchronisierwiderstände ER_{N} an die Anodenanschlüsse SA_{N} und Kathodenanschlüsse DA_{N} angeschlossen und somit parallel zu den Halbleiterschaltern HL_{N} geschaltet. Zur Erreichung einer geringen Induktivität weisen die Synchronisierwiderstände ER_{N} eine spezielle Formgebung auf.

Die räumliche Ausführungsform gemäß Figur 4 unterscheidet sich von der Ausführungsform gemäß Figur 3 dadurch, dass im gewählten Ausführungsbeispiel immer eine Schaltstufe SS_{N} auf einem einzelnen Träger ET angeordnet ist (möglich ist auch die planare Anordnung mehrerer Schaltstufen SS_{N} auf einem gemeinsamen Träger GT, wovon dann mehrere nach Art eines einzelnen Trägers ET vorgesehen sind). Dabei ist jeder zweite Träger ET ist im gewählten Ausführungsbeispiel überkopf angeordnet, sodass eine einfache Reihenkontaktierung möglich ist. Diese wird durch Flexverbinder FV hergestellt. Zur Vermeidung von Kürzschlüssen sind zwischen den einzelnen Schaltstufen SS_{N} noch Isolationsscheiben IS mit Durchführungen DF für die Flexverbinder FV vorgesehen. Die Isolationsscheiben IS können - wie die Träger GT, ET - bevorzugt aus einem keramischen Material hergestellt sein. Alle einzelnen Träger ET sind über- bzw. nebeneinander - je nach Betrachtungsweise - parallel in einen Rahmen RA eingeschoben, der aus einem gut wärmeleitenden Material besteht. Es kann sich beispielsweise um einen Metallrahmen handeln. Dieser kann auch mit einer Kühleinrichtung, beispielsweise der des Verbrauchers, verbunden sein. Der Rahmen RA kann aber auch aus einem elektrisch isolierenden Material bestehen.

### Bezugszeichenliste

- AA: äußerer Anschluss
- AN: Ansteuemetzwerk
- DA: Kathodenanschluss
- DF: Durchführung
- DK: Durchkontaktierung
- DLB: Dickschichtleiterbahn
- DSK: Dickschichtkeramik
- EB: Einstellbereich Verzögerung
- EC: Snubberkapazität
- ER: Synchronisierwiderstand
- ET: einzelner Träger
- FV: Flexverbinder
- GA: Steueranschluss
- GT: gemeinsamer Träger
- HC: Hilfskapazität
- HD: Hilfsdiode
- HL: Halbleiterschalter
- HLM: Hochleistungsschaltmodul
- IS: Isolationsscheibe
- KB: Kontaktbügel
- LVB: elektrisch leitende Lötverbindung
- N: Anzahl SS (Index)
- PTF: Pulstreiber
- PW: Primärwicklung
- RA: Rahmen
- SA: Anodenanschluss
- SD: Steuerdiode
- SR: Steuerwiderstand
- SS: Schaltstufe
- SSB: sicherer Schaltbereich HL
- SW: Sekundarwicklung
- VE: Verzögerungselement
- ZF: Zeitfenster

## Patentansprüche

1. Hochleistungsschaltmodul zur direkten Pulsenergiespeisung eines Verbrauchers mit in Reihe geschalteten Schaltstufen, die jeweils einen Halbleiterschalter mit Anoden-, Kathoden- und Steueranschluss und ein auf den Halbleiterschalter einwirkendes, mit Hilfsenergie von einem Pulstreiber versorgtes Steuemetzwerk zur Schaltbeeinflussung des Halbleiterschalters aufweisen, wobei das Steuemetzwerk zumindest einen Steuerwiderstand und eine bezüglich ankommender Schaltpulse von dem alle Schaltstufen versorgenden Pulstreiber in Durchlassrichtung gepolten Steuerdiode umfasst und wobei eine Snubberkapazität und ein zusätzlicher Synchronisierwiderstand parallel zum Halbleiterschalter zwischen Anoden- und Kathodenanschluss geschaltet sind.,
**dadurch gekennzeichnet, dass**
in jeder Schaltstufe (SSN) das Steuemetzwerk (AN_{N}) ein mit der Steuerdiode (SD_{N}) in Reihe und zum Steuerwiderstand (SR_{N}) parallel geschaltetes einstellbares Verzögerungselement (VE_{N}) zur variablen Einstellung einer den Schaltzeitpunkt des Halbleiterschalters (HL_{N}) bestimmenden, schaltstufenindividuellen Offsetspannung am Halbleiterschalter (HL_{N}) sowie eine bezüglich ankommender Schaltpulse in Sperrrichtung gepolte Hilfsdiode (HD_{N}) und eine Hilfskapazität (HC_{N}) zur Auskopplung und Speicherung von Hilfsenergie zum Halten der Offsetspannung am Halbleiterschalter (HL_{N}) umfasst.

2. Hochleistungsschaltmodul nach Anspruch 1,
**dadurch gekennzeichnet, dass**
das Verzögerungselement (VE_{N}) eine passive Kompensationsschleife oder einer aktive Regelschleife und Messvorrichtungen zur Messung der momentanen Schaltstufenspannung und der momentanen Schaltstufentemperatur umfasst.

3. Hochleistungsschaltmodul nach Anspruch 2,
**dadurch gekennzeichnet,dass**
die Steuerdiode (SD_{N}) für vorgegebene Offsetspannungswerte auch in der Sperrrichtung bezüglich der ankommenden Schaltpulse durchlässig ist.

4. Hochleistungsschaltmodul nach einem der Ansprüche 1 bis 3,
**dadurch gekennzeichnet, dass**
eine planare Ausbildung gegeben ist, wobei die einzelnen Schaltstufen (SS_{N}) auf einen gemeinsamen Träger (GT) aus einem Basismaterial (DSK) mit sehr hoher Wärmeleitfähigkeit aufgebracht sind.

5. Hochleistungsschaltmodul nach einem der Ansprüche 1 bis 3,
**dadurch gekennzeichnet, dass**
eine räumliche Ausbildung gegeben ist, wobei eine oder einer Gruppe von Schaltstufen (SS_{N}) auf einen einzelnen Träger (ET) aus einem Basismaterial mit sehr hoher Wärmeleitfähigkeit aufgebracht ist und alle Träger (ET) über- oder nebeneinander in einen Rahmen (RA) aus einem Material mit hoher Wärmeleitfähigkeit eingesteckt sind.

6. Hochleistungsschaltmodul nach Anspruch 5,
**dadurch gekennzeichnet, dass**
der Rahmen (RA) aus einem elektrisch leitenden oder elektrisch isolierenden Material ausgebildet ist.

7. Hochleistungsschaltmodul nach Anspruch 5 oder 6,
**dadurch gekennzeichnet, dass**
der Rahmen (RA) an eine Kühleinrichtung des Verbrauchers thermisch angekoppelt ist.

8. Hochleistungsschaltmodul nach einem der Ansprüche 4 bis 7,
**dadurch gekennzeichnet, dass**
das gemeinsame Basismaterial als technisches Keramikmaterial ausgebildet ist.

9. Hochleistungsschaltmodul nach einem der Ansprüche 4 bis 8,
**dadurch gekennzeichnet, dass**
das gemeinsame Basismaterial eine Beschaltung jeder Schaltstufe (SS_{N}) in Dickschichttechnologie besitzt.

10. Verfahren zur Erzeugung von Schaltsynchronität bei einem Hochleistungsschaltmodul zur direkten Pulsenergiespeisung eines Verbrauchers mit in Reihe geschalteten Schaltstufen, die jeweils einen Halbleiterschalter mit Anoden-, Kathoden- und Steueranschluss und ein auf den Halbleiterschalter einwirkendes, mit Hilfsenergie von einem Pulstreiber versorgtes Steuemetzwerk zur Verzögerung der Schaltdauer des Halbleiterschalters aufweisen, wobei das Steuemetzwerk zumindest einen Steuerwiderstand und eine bezüglich ankommender Schaltpulse von dem alle Schaltstufen versorgenden Pulstreiber in Durchlassrichtung gepolte Steuerdiode umfasst und wobei eine Snubberkapazität und ein zusätzlicher Synchronisierwiderstand parallel zum Halbleiterschalter zwischen Anoden- und Kathodenanschluss geschaltet sind, insbesondere nach einem der Ansprüche 1 bis 9,
**dadurch gekennzeichnet, dass**
in jeder Schaltstufe (SS_{N}) am Halbleiterschalter (HL_{N}) unter Ausnutzung der gespeicherten Hilfsenergie eine schaltstufenindividuelle Offsetspannung eingestellt wird, deren Wert in Abhängigkeit von der gesamten Schaltstufenkapazität, der momentanen Schaltstufenspannung und der momentanen Schaltstufentemperatur so bestimmt wird, dass die Halbleiterschalter (HL_{N}) aller Schaltstufen (SS_{N}) nach dem Eintreffen eines Schaltpulses in einem Zeitfenster (ZF) ≤ 1,5 ns ein- oder ausgeschaltet sind, wobei in jeder Schaltstufe (SS_{N}) die Hilfsenergie mittels eines den Schaltpulsen des Pulstreibers (PTF) überlagerten Wechselstroms vom Pulstreiber (PTF) abgezweigt wird

11. Verfahren nach Anspruch 10,
**dadurch gekennzeichnet, dass**
die Einstellung der schaltstufenindividuellen Offsetspannung bezüglich des Schaltzeitpunktes als Grundwert und bezüglich der momentanen Schaltstufenspannung und der momentanen Schaltstufentemperatur als Momentanwert in einer passiven Kompensationsschleife oder in einer aktiven Regelschleife erfolgt.

12. Verfahren nach Anspruch 10 oder 11,
**dadurch gekennzeichnet, dass**
die schaltstufenindividuelle Offsetspannung durch Vergleich mit einem vorgegebenen Grenzwert gleichzeitig zur Funktionsüberwachung jeder Schaltstufe eingesetzt und dem Pulstreiber (PTF) zur Auslösung der Schaltpulse zugeleitet wird.

## Claims

1. A high-power switching module for directly supplying pulse energy to a consumer with switching stages connected in series, each comprising a semiconductor switch with anode, cathode and control terminals, and a control network acting upon the semiconductor switch and supplied with auxiliary energy from a pulse driver for influencing the switching of the semiconductor switch, whereby the control network comprises at least one control resistance and one control diode poled in conducting direction with regard to incoming switching pulses from the pulse driver supplying all switching stages, and whereby a snubber capacity and an additional synchronising resistance are connected in parallel with the semiconductor switch between the anode and the cathode terminal,
**characterised in that**
at each switching stage (SS_{N}), the control network (AN_{N}) comprises an adjustable delaying element (VE_{N}) connected in parallel for variable adjustment of a switching-stage-specific offset voltage determining the switching time of the semiconductor switch (HL_{N}) at the semiconductor switch (HL_{N}) as well as an auxiliary diode (HD_{N}) poled in non-conducting direction with regard to incoming switching pulses and an auxiliary capacity (NC_{N}) for decoupling and storing auxiliary energy for maintaining the offset voltage at the semiconductor switch (HL_{N}).

2. High-power switching module according to claim 1, **characterised in that** the delaying element (VE_{N}) comprises a passive compensation loop or an active control loop and measuring devices for measuring the transient switching stage voltage and the transient switching stage temperature.

3. High-power switching module according to claim 2,
**characterised in that** the control diode (SD_{N}) for predefined offset voltage values is conducting also in non-conducting direction with regard to incoming switching pulses.

4. High-power switching module according to one of claims 1 to 3 **characterised in that** a planar shaping is given, whereby individual switching-stages (SS_{N}) are placed on a common carrier (GT) made from a base material (DSK) with very high thermal conductivity.

5. High-power switching module according to one of claims 1 to 3 **characterised in that** a spatial shaping is given, whereby one or a group of switching stages (SS_{N}) are placed on a single carrier (ET) made from a base material with very high thermal conductivity and all carriers (ET) are plugged on top of or next to each other into a frame (RA) made from a material with high thermal conductivity.

6. High-power switching module according to claim 5 **characterised in that** the frame (RA) is formed of an electrically conducting or electrically insulating material.

7. High-power switching module according to claim 5 or 6, **characterised in that** the frame (RA) is thermally coupled to a cooling facility of the consumer.

8. High-power switching module according to one of claims 4 to 7, **characterised in that** the common base material is a technical ceramic material.

9. High-power switching module according to one of claims 4 to 8, **characterised in that** the common base material includes a wiring of each switching stage (SS_{N}) in thick film technology.

10. Method for the generation of switching synchronism in a high-power switching module for directly supplying pulse energy to a consumer with switching stages connected in series, each comprising a semiconductor switch with anode, cathode and control terminals, and a control network acting upon the semiconductor switch and supplied with auxiliary energy from a pulse driver for delaying the switching duration of the semiconductor switch, whereby the control network comprises at least one control resistance and one conducting control diode with regard to incoming switching pulses from the pulse driver supplying all switching stages, and whereby a snubber capacity and an additional synchronising resistance are connected in parallel with the semiconductor switch between the anode and the cathode terminals, in particular according to one of claims 1 to 9,
**characterised in that**
at each switching stage (SS_{N}), a switching-stage-specific offset voltage is set at the semiconductor switch (HL_{N}) utilising the stored auxiliary energy, the value of which is determined depending upon the switching stage capacity as a whole, the transient switching stage voltage and the transient switching stage temperature, in such a way that the semiconductor switches (HL_{N}) of all switching stages (SS_{N}), after the arrival of a switching pulse, are switched ≤ 1.5ns on or off in a time window (ZF), whereby, at each switching stage (SS_{N}), the auxiliary energy is diverted away from the pulse driver (PTF) by means of an alternating current superimposed on the switching pulses of the pulse driver (PTF).

11. Method according to claim 10, **characterised in that** the switching-stage-specific offset voltage, with regard to the switching time, is set as a basic value and, with regard to the transient switching stage voltage and the transient switching stage temperature, is set as a transient value in a passive compensation loop or in an active control loop.

12. Method according to claim 10 or 11, **characterised in that** the switching-stage-specific offset voltage is simultaneously used for monitoring the function of each switching stage by comparing it with a predefined limit value and is fed to the pulse driver (PTF) for triggering the switching pulses.

## Revendications

1. Module de commutation à haute performance pour l'alimentation directe en énergie d'impulsion d'un consommateur avec des étages de commutation montés en série, qui présentent chacun un commutateur statique avec branchement d'anode, branchement de cathode et branchement de commande et un réseau de commande agissant sur le commutateur statique, alimenté en énergie auxiliaire par un driver d'impulsion pour influencer la commutation de commutateur statique, le réseau de commande comprenant au moins une résistance de commande et une diode de commande polarisée par rapport à des impulsions de commutation arrivant par le driver d'impulsion alimentant tous les étages de commutation dans le sens de passage et un condensateur Snubber et une résistance de synchronisation supplémentaire étant montés parallèlement au commutateur statique entre le branchement de l'anode et le branchement de cathode,
**caractérisé en ce que**,
à chaque étage de commutation (SSN), le réseau de commande (AN_{N}) comprend un élément de temporisation (VE_{N}) réglable, monté en série avec la diode de commande (SD_{N}) et en parallèle avec la résistance de commande (SR_{N}) pour le réglage variable d'une tension offset déterminant le moment de commutation du commutateur statique (HL_{N}) et individuel par étage de commutation sur le commutateur statique (HL_{N}) et une diode auxiliaire (HD_{N}) polarisée dans le sens de blocage par rapport à des impulsions de commutation arrivant et un condensateur auxiliaire (HC_{N}) pour la dissociation et le stockage d'énergie auxiliaire pour le maintien de la tension offset sur le commutateur statique (HL_{N}).

2. Module de commutation à haute performance selon la revendication 1,
**caractérisé en ce que**
l'élément de temporisation (VE_{N}) comporte une boucle de compensation passive ou une boucle de réglage active et des dispositifs de mesure pour la mesure de la tension momentanée d'étage de commutation et de la température momentanée d'étage de commutation.

3. Module de commutation à haute performance selon la revendication 2,
**caractérisé en ce que**
la diode de commande (SD_{N}) est perméable pour des valeurs de tension offset prédéfinies également dans le sens de blocage par rapport aux impulsions de commutation arrivant.

4. Module de commutation à haute performance selon l'une quelconque des revendications 1 à 3,
**caractérisé en ce que**
on a une réalisation planaire, les étages de commutation (SS_{N}) individuels étant appliqués sur un support commun (GT) fait dans un matériau de base (DSK) présentant une conductibilité thermique très élevée.

5. Module de commutation à haute performance selon l'une quelconque des revendications 1 à 3,
**caractérisé en ce que**
on a une réalisation dans l'espace, un étage de commutation ou un groupe d'étages de commutation (SS_{N}) étant appliqué sur un support individuel (ET) fait dans un matériau de base présentant une conductibilité thermique très élevée et tous les supports (ET) étant emboîtés les uns au-dessus des autres ou les uns à côté des autres dans un cadre (RA) à base d'un matériau présentant une conductibilité thermique élevée.

6. Module de commutation à haute performance selon la revendication 5,
**caractérisé en ce que**
le cadre (RA) est réalisé à base d'un matériau électroconducteur ou électroisolant.

7. Module de commutation à haute performance selon la revendication 5 ou 6,
**caractérisé en ce que**
le cadre (RA) est couplé thermiquement à un dispositif de refroidissement du consommateur.

8. Module de commutation à haute performance selon l'une quelconque des revendications 4 à 7,
**caractérisé en ce que**
le matériau de base commun est conçu sous forme de matériau céramique technique.

9. Module de commutation à haute performance selon l'une quelconque des revendications 4 à 8,
**caractérisé en ce que**
le matériau de base commun présente une connexion de chaque étage de commutation (SS_{N}) dans une technologie à couche épaisse.

10. Procédé pour générer un synchronisme de commutation dans le cas d'un module de commutation à haute performance pour l'alimentation directe en énergie d'impulsion d'un consommateur avec des étages de commutation montés en série, lesquels présentent chacun un commutateur statique avec branchement d'anode, branchement de cathode et branchement de commande et un réseau de commande agissant sur le commutateur statique et alimenté en énergie auxiliaire par un driver d'impulsion pour temporiser la durée de commutation du commutateur statique, le réseau de commande comprenant au moins une résistance de commande et une diode de commande polarisée par rapport à des impulsions de commutation arrivant par le driver d'impulsion alimentant tous les étages de commutation dans le sens de passage et un condensateur Snubber et une résistance de synchronisation supplémentaire étant branchés parallèlement au commutateur statique entre le branchement d'anode et le branchement de cathode, en particulier selon l'une quelconque des revendications 1 à 9,
**caractérisé en ce que,**
sur chaque étage de commutation (SS_{N}), une tension offset individuelle par étage de commutation est réglée sur le commutateur statique (HL_{N}) avec utilisation de l'énergie auxiliaire stockée, tension dont la valeur est déterminée en fonction de la capacité globale de l'étage de commutation, de la tension momentanée de l'étage de commutation et de la température momentanée de l'étage de commutation, de telle sorte que les commutateurs statiques (HL_{N}) de tous les étages de commutation (SS_{N}) sont connectés ou déconnectés après l'arrivée d'une impulsion de commutation dans une fenêtre de temps (ZF) ≤ 1,5 ns, l'énergie auxiliaire étant dérivée à chaque étage de commutation (SS_{N}) du driver d'impulsion (PTF) au moyen d'un courant alternatif superposé aux impulsions de commutation du driver d'impulsion (PTF).

11. Procédé selon la revendication 10,
**caractérisé en ce que**
le réglage de la tension offset individuelle par étage de commutation s'effectue par rapport au moment de commutation comme valeur de base et par rapport à la tension momentanée de l'étage de commutation et à la température momentanée de l'étage de commutation comme valeur momentanée dans une boucle de compensation passive ou dans une boucle de réglage active.

12. Procédé selon la revendication 10 ou 11,
**caractérisé en ce que**
la tension offset individuelle par étage de commutation est utilisée par comparaison avec une valeur limite prédéfinie en même temps que le contrôle du fonctionnement de chaque étage de commutation et est acheminée au driver d'impulsion (PTF) pour le déclenchement des impulsions de commutation.
